# EUROPEAN PATENT APPLICATION

(11) **EP 4 202 090 A1**
(43) Date of publication of application: **28.06.2023**
(21) Application number: 21858342.5
(22) Date of filing: 18.08.2021
(51) Int. Cl.: C30B 29/38, C23C 16/34, C30B 25/20, H01L 21/205

(54) **GAN CRYSTAL AND GAN SUBSTRATE**

(30) Priority: 21.08.2020 JP 2020140004
(71) Applicant: Mitsubishi Chemical Corporation, Chiyoda-ku Tokyo 100-8251 (JP); National Institute for Materials Science, Tsukuba-shi, Ibaraki 305-0047 (JP)
(72) Inventor: TSUKADA, Yusuke, Tokyo 100-8251 (JP); OSHIMA, Yuichi, Tsukuba-shi, Ibaraki 305-0047 (JP); ENATSU, Yuuki, Tokyo 100-8251 (JP)
(74) Representative: Hoffmann Eitle
(86) International application number: PCT/JP2021/030208
(87) International publication number: WO 2022/039198

(57) **Abstract**

Provided are: a GaN crystal used in a substrate for a nitride semiconductor device having a horizontal device structure, such as a GaN-HEMT; and a GaN substrate used for the production of a nitride semiconductor device having a horizontal device structure, such as a GaN-HEMT. The GaN crystal and the GaN substrate each include a surface having an inclination of 10° or less from a (0001) crystal plane and an area of 5 cm² or more, and have an Mn concentration of 1.0 × 10¹⁶ atoms/cm³ or higher but lower than 1.0 × 10¹⁹ atoms/cm³ and a total donor impurity concentration of lower than 5.0 × 10¹⁶ atoms/cm³.

## Description

### TECHNICAL FIELD

The present invention relates to a GaN crystal and a GaN substrate, particularly a semi-insulating GaN crystal and a semi-insulating GaN substrate.

### BACKGROUND ART

GaN (gallium nitride) is one of Group III nitride compounds and has a wurtzite-type crystal structure belonging to a hexagonal system.

In recent years, as substrates for GaN-HEMTs (High Electron Mobility Transistors), a substrate on which a semi-insulating GaN layer is arranged as a surface layer and a single-crystal GaN substrate entirely composed of a semi-insulating GaN crystal have been studied (Patent Document 1) .

The term "semi-insulating GaN" used herein means GaN having an increased resistance, and usually has a room-temperature resistivity of 1 × 10⁵ Q·cm or higher.

It is known that, in order to impart GaN with a semi-insulating property, GaN may be doped with an impurity (compensating impurity) having an effect of compensating an n-type carrier, such as Fe (iron), Mn (manganese), or C (carbon).

According to Non-patent Document 1, when a GaN crystal having an Mn concentration of 2 × 10¹⁷ cm⁻³ was homoepitaxially grown on a GaN substrate by HVPE (Hydride Vapor Phase Epitaxy), the concentration of a donor impurity, Si, was found to be 6 × 10¹⁶ cm⁻³. It is believed that the Si element of this concentration was unintentionally introduced into the crystal under the environment of HVPE growth; therefore, the concentration of Si element can be said to be independent of the Mn concentration.

### RELATED ART DOCUMENT

### PATENT DOCUMENT

[Patent Document 1] Japanese Unexamined Patent Application Publication No. 2012-246195

### NON-PATENT DOCUMENT

[Non-patent Document 1] Japanese Journal of Applied Physics, vol. 58, SC1047

### SUMMARY OF THE INVENTION

### PROBLEMS TO BE SOLVED BY THE INVENTION

The present inventors studied Mn-doped semi-insulating GaN in order to obtain a GaN substrate used for a GaN-HEMT. As a result, it was confirmed that, although an increase in the Mn doping amount leads to an increase the resistance of a GaN crystal, it causes an increase in the threading dislocation density and makes the GaN crystal itself brittle as compared to an undoped GaN crystal, as a result of which the crystal quality is deteriorated.

In this manner, an Mn-doped GaN crystal that exhibits not only a sufficiently high resistance but also a good crystal quality comparable to that of an undoped GaN crystal has not been obtained at present.

An object of the present invention is to obtain a GaN crystal which can be used in a substrate for a nitride semiconductor device having a horizontal device structure, such as a GaN-HEMT.

Another object of the present invention is to obtain a GaN substrate which can be used for the production of a nitride semiconductor device having a horizontal device structure, such as a GaN-HEMT.

### MEANS FOR SOLVING THE PROBLEMS

The present inventors intensively studied to discover that, in a GaN crystal, the balance between the concentration of Mn, which is a compensating impurity contributing to an increase in the resistance, and the concentration of a donor impurity which inhibits the resistance-increasing effect exerted by the compensating impurity is important, and that the above-described problems can be solved by optimizing this balance. Specifically, the present inventors discovered that a GaN crystal which has a good quality despite being semi-insulating can be obtained by doping an HVPE-grown GaN crystal with Mn at an appropriate concentration while maintaining a low donor impurity concentration during the doping with Mn, thereby arriving at the present invention.

That is, the gist of the present invention is as follows.
[1] A GaN crystal, characterized by including a surface which has an inclination of 10° or less from a (0001) crystal plane and an area of 5 cm² or more, and having an Mn concentration of 1.0 × 10¹⁶ atoms/cm³ or higher but lower than 1.0 × 10¹⁹ atoms/cm³ and a total donor impurity concentration of lower than 5.0 × 10¹⁶ atoms/cm³.
[2] The GaN crystal according [1], wherein the Mn concentration is 6.0 × 10¹⁸ atoms/cm³ or lower.
[3] The GaN crystal according to [1] or [2], wherein the Mn concentration is 1.0 × 10¹⁷ atoms/cm³ or higher.
[4] The GaN crystal according to any one of [1] to [3], having a (004) XRD rocking curve full width at half maximum, which is measured on the side of the (0001) surface, of 40 arcsec or less.
[5] The GaN crystal according to any one of [1] to [4], having a threading dislocation density of less than 1.0 × 10⁷ cm⁻² on the (0001) surface.
[6] A GaN crystal, characterized by including a surface which has an inclination of 10° or less from a (0001) crystal plane and an area of 5 cm² or more, being semi-insulating, and satisfying at least one selected from the following (A) and (B):
   (A) having a (0004) XRD rocking curve full width at half maximum, which is measured on the side of the (0001) surface, of 40 arcsec or less; and
   (B) having a threading dislocation density of less than 1 × 10⁷ cm⁻² on the (0001) surface.
[7] The GaN crystal according to [6], which is doped with Mn.
[8] The GaN crystal according to [6] or [7], having a total donor impurity concentration of lower than 5.0 × 10¹⁶ atoms/cm³.
[9] A GaN substrate, including the GaN crystal according to any one of [1] to [8].
[10] A GaN substrate, characterized by including, as a main surface, a surface which has an inclination of 10° or less from a (0001) crystal plane, and having an Mn concentration of 1.0 × 10¹⁶ atoms/cm³ or higher but lower than 1.0 × 10¹⁹ atoms/cm³ and a total donor impurity concentration of lower than 5.0 × 10¹⁶ atoms/cm³.
[11] The GaN substrate according to [9] or [10], which is a single-crystal GaN substrate.
[12] The GaN substrate according to [10] or [11], which is laminated on a support substrate.
[13] A method of producing an epitaxial wafer, the method including:
   the step of preparing the GaN substrate according to any one of [10] to [12]; and
   the step of epitaxially growing at least one nitride semiconductor layer on the thus prepared substrate.
[14] An epitaxial wafer, including:
   the GaN substrate according to any one of [10] to [12]; and
   at least one nitride semiconductor layer epitaxially grown on the substrate.
[15] A method of producing a nitride semiconductor device, the method including:
   the step of preparing the GaN substrate according to any one of [10] to [12]; and
   the step of epitaxially growing at least one nitride semiconductor layer on the thus prepared substrate.
[16] A method of producing a GaN-HEMT, the method including:
   the step of preparing the GaN substrate according to any one of [10] to [12]; and
   the step of epitaxially growing at least one nitride semiconductor layer on the thus prepared substrate.
[17] A GaN substrate, including a GaN crystal laminated on a support substrate,
   wherein
   the GaN crystal includes a surface which has an inclination of 10° or less from a (0001) crystal plane and an area of 5 cm² or more, and
   the Mn concentration at a position less than 2 um away from an interface of the GaN crystal and the support substrate in the [0001] direction is 20 times or less of the Mn concentration at a position 2 um or more away from the interface in the [0001] direction.

### EFFECTS OF THE INVENTION

According to the present invention, a GaN crystal which not only can exhibit a semi-insulating property even when it has a relatively low concentration of Mn that is a compensating impurity, but also has a good crystal quality is provided. Therefore, a GaN crystal which can be preferably used in a substrate for a nitride semiconductor device having a horizontal device structure, such as a GaN-HEMT, as well as a GaN substrate which can be preferably used for the production of a horizontal nitride semiconductor device such as a GaN-HEMT are provided.

### BRIEF DESCRIPTION OF THE DRAWINGS

[FIG. 1] FIG. 1 is a perspective view illustrating a GaN crystal according to one embodiment.
[FIG. 2] FIG. 2 is a plan view illustrating a (0001) surface of the GaN crystal according to one embodiment, which is divided by a square lattice into 5 mm × 5 mm cells.
[FIG. 3] FIG. 3 is a perspective view illustrating a single-crystal GaN substrate according to one embodiment.
[FIG. 4] FIG. 4 is a cross-sectional view illustrating the single-crystal GaN substrate according to one embodiment.
[FIG. 5] FIG. 5 is a cross-sectional view illustrating a single-crystal GaN substrate according to another embodiment.
[FIG. 6] FIG. 6 is a schematic drawing that illustrates a basic configuration of an HVPE apparatus suitable for growing a GaN crystal according to one embodiment.
[FIG. 7] FIG. 7 is a graph showing the relationship between the susceptor temperature of an HVPE apparatus and the impurity concentrations of a grown GaN crystal.
[FIG. 8] FIG. 8 is a graph showing the relationship between the Ga reservoir temperature and the Mn, Si, and O concentrations of a grown GaN crystal.

### MODE FOR CARRYING OUT THE INVENTION

In a GaN crystal, a crystallographic axis parallel to [0001] and [000-1] is referred to as "c-axis", a crystallographic axis parallel to <10-10> is referred to as "m-axis", and a crystallographic axis parallel to <11-20> is referred to as "a-axis". A crystallographic plane perpendicular to the c-axis is referred to as "c-plane", a crystallographic plane perpendicular to the m-axis is referred to as "m-plane", and a crystallographic plane perpendicular to the a-axis is referred to as "a-plane".

Unless otherwise specified, the terms "crystal axis", "crystal plane", "crystal orientation" and the like that are used herein mean a crystallographic axis, a crystallographic plane, a crystal orientation and the like of a GaN crystal, respectively.

The Miller indices (hkil) of a hexagonal crystal has a relationship of h + k = i and, therefore, may be expressed in three digits of (hkl). For example, (0004) is expressed as "(004)" in three digits.

In the present specification, those numerical ranges stated with "to" each denote a range that includes the numerical values stated before and after "to" as the lower limit value and the upper limit value, respectively, and an expression "A to B" means a value that is A or more but B or less.

Embodiments of the present invention will now be described referring to the drawings as appropriate. Embodiments of the present invention include, but not limited to, the below-described modes.

### 1.GaN Crystal

A first embodiment of the present invention relates to a GaN crystal.

The GaN crystal according to the first embodiment (hereinafter, also simply referred to as "GaN crystal") includes a surface which has an inclination of 10° or less (including 0°) from a (0001) crystal plane and an area of 5 cm² or more. Hereinafter, the "surface which has an inclination of 10° or less (including 0°) from a (0001) crystal plane" may be simply referred to as "(0001) surface". The above-described GaN crystal may have various thicknesses, and can take various forms of, for example, a self-supporting substrate, an epitaxial layer grown on other GaN crystal, and a GaN layer laminated on a support substrate by a bonding technology. The GaN crystal according to the first embodiment may have any shape, and the shape is preferably one from which the below-described GaN substrate can be obtained.

The area of the (0001) surface may be 18 cm² or larger, 75 cm² or larger, or 165 cm² or larger, and it may be 350 cm² or smaller.

The GaN crystal according to the first embodiment may be a GaN crystal grown in any direction; however, it is preferably a GaN crystal grown on a surface which has an inclination of 10° or less (including 0°) from a (0001) crystal plane.

In the GaN crystal according to the first embodiment, the (0001) surface preferably constitutes a main surface (large-area surface). Further, the area ratio of the (0001) surface in the crystal growth surface is preferably not less than 60%, more preferably not less than 70%, still more preferably not less than 80%, and an upper limit thereof is 100%.

When the (0001) surface has a large area, as described below, the donor impurity concentrations can be reduced, and the GaN crystal can exhibit a semi-insulating property even when it has a relatively low Mn concentration. This is also the same when the area ratio of the (0001) surface in the crystal growth surface is in the above-described range.

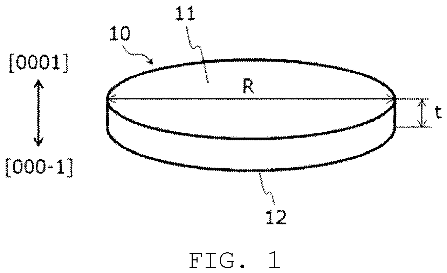

A crystal 10 illustrated in FIG. 1 is one example of the GaN crystal according to the first embodiment.

The crystal 10 has a (0001) surface 11 which is Ga-polar, and a (000-1) surface 12 which is N-polar. In other words, the crystal 10 is an example of a GaN crystal which grows on the (0001) surface and in which the (0001) surface constitutes a main surface.

In the crystal 10, the inclination of the (0001) surface 11 from a (0001) crystal plane may be, for example, 0° or more but less than 0.5°, 0.5° or more but less than 1°, 1° or more but less than 1.5°, 1.5° or more but less than 2.5°, 2.5° or more but less than 5°, or 5° or more but less than 10°. The inclination is preferably less than 2.5°.

The feature that a surface of the crystal 10 is such a crystal surface is closely relates to that unintended doping of a donor impurity is inhibited or controlled in the growth process.

It is not essential that the entirety of the (0001) surface 11 illustrated in FIG. 1 has an inclination in the above-described numerical range. In this case, the (0001) surface (or (0001) surface 11) may be paraphrased as "main surface A", and a region of the main surface A, which has an area of at least 5 cm², may be a (0001) surface having an inclination in the above-described numerical range. The entire (0001) surface 11 or the region of the (0001) surface which an inclination in the above-described numerical range may have an area of 18 cm² or larger, 75 cm² or larger, or 165 cm² or larger, and the area may be 350 cm² or smaller.

The thickness t is usually 1 um or more, and an upper limit thereof is not particularly limited; however, it is usually 4 mm or less. The thickness t may be, for example, 5 µm or more but less than 200 µm, 200 um or more but less than 500 um, 500 um or more but less than 1 mm, or 1 mm or more.

The (0001) surface 11 preferably has a shape that can enclose a circle having a diameter of not less than 20 mm. The (0001) surface 11 also preferably has a shape from which the below-described GaN substrate can be obtained. Therefore, the (0001) surface 11 preferably has a shape that can enclose a circle having a diameter larger than the diameter R of the below-described substrate 100.

The GaN crystal according to the first embodiment is doped with Mn and has an Mn concentration of 1.0 × 10¹⁶ atoms/cm³ or higher but lower than 1.0 × 10¹¹ atoms/cm³ and a total donor impurity concentration of lower than 5.0 × 10¹⁶ atoms/cm³. Mn, which is a compensating impurity, contributes to an increase in the resistance, and a donor impurity inhibits the resistance-increasing effect exerted by the compensating impurity. Further, from the standpoint of the impurity level, doping with Mn is superior to doping with other compensating impurity such as Fe. This is because, since Mn has a deeper level than Fe, a larger amount of energy is required for a trapped electron to return back to a conduction band.

The total donor impurity concentration is preferably lower than 4.0 × 10¹⁶ atoms/cm³, more preferably lower than 2.0 × 10¹⁶ atoms/cm³. Further, in another mode of the GaN crystal, at least either of the Mn concentration and the total donor impurity concentration satisfy the above-described respective range, and it is particularly preferred that at least the donor impurity concentration satisfy the above-described range.

The term "total donor impurity concentration" used herein refers to a total concentration of donor impurities that are contained in the GaN crystal according to the first embodiment. As impurities that act as donors for GaN, for example, O (oxygen), Si (silicon), S (sulfur), Ge (germanium), and Sn (tin) are known.

As described below, the GaN crystal according to the first embodiment can be grown by HVPE (Hydride Vapor Phase Epitaxy); therefore, O (oxygen) and Si (silicon) can each be incorporated into the GaN crystal at a concentration in the order of 10¹⁵ atoms/cm³ or higher, despite not being intentionally added. On the other hand, the only time when other donor impurity excluding O and Si is incorporated into the GaN crystal according to the first embodiment at a non-negligible concentration is when the GaN crystal is intentionally doped with such a donor impurity. It is noted here that the term "intentionally doped" used herein means, for example, a case where an element of interest is added as a raw material in the form of a simple substance or a compound for the purpose of doping the GaN crystal with the element.

Accordingly, unless an donor impurity excluding O and Si is intentionally doped, the total donor impurity concentration of the GaN crystal according to the first embodiment may be deemed to be equal to a sum of the O concentration and the Si concentration. Whether or not the GaN crystal is doped with a donor impurity other than O and Si can be verified by an elemental analysis or the like.

The GaN crystal according to the first embodiment has not only a large difference between the Mn concentration and the total donor impurity concentration but also a low total donor impurity concentration; therefore, the GaN crystal according to the first embodiment is characterized in that its resistivity is hardly affected by fluctuations in the donor impurity concentration.

In addition, the GaN crystal according to the first embodiment has a major characteristic that, because of the low total donor impurity concentration, it can realize a high resistivity at a relatively low Mn concentration.

The Mn concentration of the GaN crystal according to the first embodiment may be 6.0 × 10¹⁸ atoms/cm³ or lower, 5.0 × 10¹⁸ atoms/cm³ or lower, 3.0 × 10¹⁸ atoms/cm³ or lower, 1.0 × 10¹⁸ atoms/cm³ or lower, or 8.0 × 10¹⁷ atoms/cm³ or lower, but 1.0 × 10¹⁶ atoms/cm³ or higher, 3.0 × 10¹⁶ atoms/cm³ or higher, 5.0 × 10¹⁶ atoms/cm³ or higher, 1.0 × 10¹⁷ atoms/cm³ or higher, 3.0 × 10¹⁷ atoms/cm³ or higher, or 5.0 × 10¹⁷ atoms/cm³ or higher.

As long as the total donor impurity concentration is lower than 5.0 × 10¹⁶ atoms/cm³, the room-temperature resistivity of the GaN crystal can reach 1 × 10¹¹ Ω·cm or higher, 2 × 10¹¹ Ω·cm or higher, or even 5 × 10¹¹ Ω·cm or higher, when the Mn concentration is 1 × 10¹⁷ atoms/cm³. Further, the room-temperature resistivity of the GaN crystal can reach 5 × 10¹² Ω·cm when the Mn concentration is 1 × 10¹⁸ atoms/cm³, or 7 × 10¹² Ω·cm when the Mn concentration is 3 × 10¹⁸ atoms/cm³.

The feature that the concentration of Mn, which needs to be added to the GaN crystal, can be reduced to obtain the same resistivity is convenient for inhibiting deterioration of the crystal quality and reduction in the thermal conductivity that are caused by an addition of Mn.

It is noted here that the concentrations of donor impurities, compensating impurities, and other elements in the GaN crystal can be measured by secondary ion mass spectrometry (SIMS).

The GaN crystal according to the first embodiment may also contain C, which is a compensating impurity, at a concentration of not lower than a detection lower limit (about 5 × 10¹⁵ atoms/cm³) of secondary ion mass spectrometry (SIMS), preferably lower than 1 × 10¹⁷ atoms/cm³, more preferably lower than 5 × 10¹⁶ atoms/cm³.

The GaN crystal according to the first embodiment may further contain an compensating impurity other than Mn and C, such as Fe (iron), Co (cobalt), or Ni (nickel), as long as it does cause a practical problem.

The GaN crystal according to the first embodiment may also contain H (hydrogen) in addition to the above-mentioned impurities, and the concentration thereof may be, for example, in the order of 10¹⁶ to 10¹⁷ atoms/cm³ (specifically 1 × 10¹⁶ atoms/cm³ or higher but lower than 1 × 10¹⁸ atoms/cm³).

The (0004) XRD rocking curve full width at half maximum of the GaN crystal, which is measured on the side of the (0001) surface, is preferably 40 arcsec or less, more preferably 30 arcsec or less, still more preferably 20 arcsec or less, yet still more preferably 18 arcsec or less, further preferably 16 arcsec or less, further more preferably 14 arcsec or less, yet further more preferably 12 arcsec or less. It is noted here that the "full width at half maximum" is synonymous with what is generally referred to as "half-value width". The full width at half maximum can be adjusted by changing, for example, the method of growing the GaN crystal (e.g., a vapor-phase method or a liquid-phase method), the crystal characteristics of a seed substrate used for growing the GaN crystal, the crystal growth conditions, the selection of a growth surface, or the content of an impurity.

The (0004) XRD rocking curve is an index representing the crystal quality and is measured using CuKα₁ radiation. In the measurement, an X-ray tube is operated at, for example, a voltage of 45 kV and a current of 40 mA.

In the measurement of the (0004) XRD rocking curve, when an X-ray is irradiated to the (0001) surface, the plane of incidence of the X-ray can be perpendicular to the a-axis or the m-axis.

The X-ray beam size can be set such that, when the angle of incidence (an angle formed by a reflection surface and the X-ray) is 90°, i.e. when the X-ray is irradiated perpendicular to the (0004) surface that is a reflection surface, the irradiated area on the (0001) surface has a size of 5 mm in the direction parallel to the ω-axis and 1 mm in the direction perpendicular to the ω-axis. The term "ω-axis" used herein refers to the rotation axis of a sample in the rocking curve measurement.

When the X-ray beam size is set in the above-described manner, the value of ω is about 36.5° in the (0004) XRD rocking curve measurement; therefore, the size of the irradiated area is about 1.7 × 5 mm².

The GaN crystal according to the first embodiment has a threading dislocation density (which is hereinafter simply referred to as "dislocation density" and synonymous with the dark spot density determined by the cathodoluminescence (CL) method described below in Experimental Examples) of usually less than 1 × 10⁷ cm⁻², preferably less than 5 × 10⁶ cm⁻², more preferably less than 1 × 10⁶ cm⁻², still more preferably less than 5 × 10⁵ cm⁻², further preferably less than 1 × 10⁵ cm⁻². The dislocation density can be adjusted by changing, for example, the method of growing the GaN crystal (e.g., a vapor-phase method or a liquid-phase method), the crystal characteristics of a seed substrate used for growing the GaN crystal, the crystal growth conditions, the selection of a growth surface, or the content of an impurity.

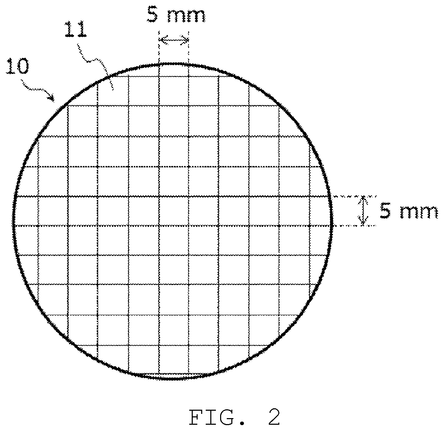

In a particularly preferred example, when the (0001) surface of the GaN crystal according to the first embodiment is divided by a square lattice into 5 mm × 5 mm cells as illustrated in FIG. 2, at least one 100 µm × 100 µm square region having no threading dislocation exists in each of the 5 mm × 5 mm cells.

There are three kinds of threading dislocations, which are edge, screw, and mixed dislocations; however, in the present specification, these are collectively referred to as "threading dislocations" without being distinguished from one another.

The presence or absence and the density of threading dislocations in the GaN crystal according to the first embodiment can be examined by 1-hour etching of the GaN crystal with 89% sulfuric acid heated to 270°C. Etch pits formed on the (0001) surface by this etching corresponds to threading dislocations, and the density of the etch pits is equivalent to the threading dislocation density. This has been confirmed by examining the correspondence between etch pits formed by etching of a conductive GaN crystal grown by HVPE under the same conditions and dark spots appearing on a cathodoluminescence (CL) image.

Another mode of the GaN crystal according to the first embodiment satisfies at least one selected from the above-described preferred range of the (0004) XRD rocking curve full width at half maximum of the GaN crystal, which is measured on the side of the (0001) surface, and the above-described preferred range of the threading dislocation density on the (0001) surface. In this GaN crystal of another embodiment, the above-described conditions of the GaN crystal according to the first mode or the conditions of the GaN crystal described as another mode are preferably applied.

A method of obtaining the above-described GaN crystal is not limited; however, specifically, the GaN crystal can be obtained by, for example, the below-described method of growing a GaN crystal.

### 2. GaN Substrate

A second embodiment of the present invention relates to a GaN substrate.

The GaN substrate according to the second embodiment includes, as a main surface, a surface having an inclination of 10° or less from a (0001) crystal plane, and has an Mn concentration of 1.0 × 10¹⁶ atoms/cm³ or higher but lower than 1.0 × 10¹⁹ atoms/cm³ and a total donor impurity concentration of lower than 5.0 × 10¹⁶ atoms/cm³. The surface having an inclination of 10° or less from a (0001) crystal plane preferably has an area of 5 cm² or more. Particularly, the GaN substrate according to the second embodiment is preferably a single-crystal GaN substrate, more preferably a self-supporting substrate consisting of only a single-crystal GaN.

The GaN substrate according to the second embodiment can be preferably obtained from the GaN crystal according to the first embodiment; however, it is not limited to be a GaN substrate obtained from the GaN crystal according to the first embodiment.

Further, when a GaN crystal is grown on a support substrate and a GaN substrate is obtained from this GaN crystal, the GaN substrate may have a structure in which the support substrate and the GaN crystal are laminated. In this case, the GaN crystal portion may satisfy the above-described requirements.

The GaN substrate according to the second embodiment is preferably at least partially constituted by the above-described GaN crystal according to the first embodiment. In this case, the GaN substrate according to the second embodiment can exert the same effects as those exerted by the GaN crystal according to the first embodiment.

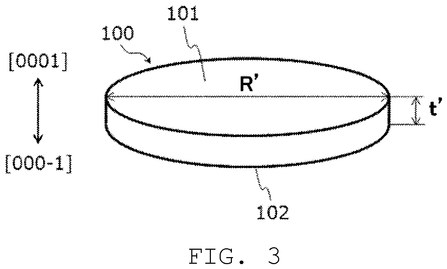

A substrate 100 illustrated in FIG. 3 is one example of the GaN substrate according to the second embodiment, and has a (0001) surface 101 which is Ga-polar, and a (000-1) surface 102 which is N-polar.

The substrate 100 has a diameter R' of usually 20 mm or more, and the diameter R' is typically, for example, 25 to 27 mm (about 1 inch), 50 to 55 mm (about 2 inches), 100 to 105 mm (about 4 inches), or 150 to 155 mm (about 6 inches).

The thickness t' of the substrate 100 is set in accordance with the diameter R' at a value that does not make handling of the substrate 100 difficult. For example, when the diameter R' of the substrate 100 is about 2 inches, the thickness t' is preferably 250 to 500 um, more preferably 300 to 450 µm.

Of the two large-area surfaces of the substrate 100, the (0001) surface 101 is the surface that is used as a front surface for epitaxial growth of a nitride semiconductor layer. The (0001) surface 101 is mirror-finished, and the root-mean-square (RMS) roughness thereof, which is measured under an AFM, is usually less than 2 nm, preferably less than 1 nm, more preferably less than 0.5 nm, in a measurement area of 2 um × 2 um.

The (000-1) surface 102 serves as a back surface, and thus may be mirror-finished or mat-finished (roughened surface).

The edges of the substrate 100 may be chamfered as well.

As required, the substrate 100 may be provided with various markings, such as an orientation flat or notch that indicates the crystal orientation, and an index flat for making it easier to distinguish the front surface from the back surface.

The substrate 100 has a disk shape; however, in a modification example, the (0001) surface 101 and the (000-1) surface 102 may have a square shape, a rectangular shape, a hexagonal shape, an octagonal shape, an elliptical shape or the like, or may have an amorphous shape.

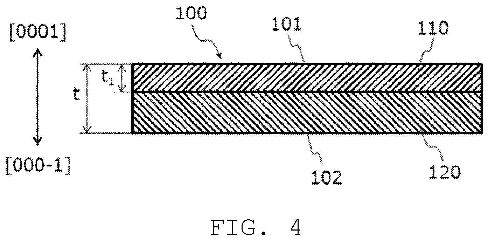

FIG. 4 illustrates a cut surface obtained by cutting the substrate 100 with a flat plane perpendicular to the

### (0001) surface 101.

In the substrate 100, a first region 110 including the (0001) surface 101 may be formed of the above-described GaN crystal according to the first embodiment.

When the thickness t₁ of the first region 110 is less than the thickness t' of the substrate 100, the substrate 100 has a second region 120 on the side of the (000-1) surface 102 as illustrated in FIG. 4.

The second region 120 may be formed of a GaN crystal having a room-temperature resistivity of less than 1 × 10⁵ Ω·cm (i.e., a GaN crystal that is not semi-insulating).

The total compensating impurity concentration in the second region 120 is usually lower than that in the first region 110. In the vicinity of the boundary with the first region 110, the second region 120 may have a region in which the total compensating impurity concentration increases in a stepwise or continuous manner toward the first region 110.

The substrate 100 having the first region 110 and the second region 120 can be produced by forming the second region 120 by epitaxial growth on the first region 110, or by forming the first region 110 by epitaxial growth on the second region 120.

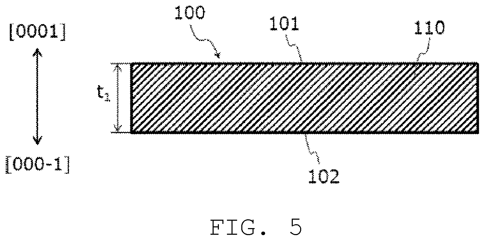

In one example, as illustrated in FIG. 5, the thickness of the substrate 100 may be equal to the thickness t₁ of the first region 110. In other words, the substrate 100 may consist of only the GaN crystal according to the first embodiment.

A third embodiment of the present invention is a GaN substrate in which a GaN crystal, which has a surface having an inclination of 10° or less from a (0001) crystal plane and an area of 5 cm² or more, is laminated on a support substrate and, in this GaN substrate, the Mn concentration at a position less than 2 um away from an interface of the GaN crystal and the support substrate in the [0001] direction is 20 times or less of the Mn concentration at a position 2 um or more away from the interface in the [0001] direction.

The GaN crystal in the GaN substrate according to the third embodiment may be the GaN crystal according to the first embodiment. Further, the GaN substrate according to the third embodiment may be equivalent to the GaN substrate according to the second embodiment.

The position less than 2 um away from an interface of the GaN crystal and the support substrate in the [0001] direction and the position 2 um or more away from the interface in the [0001] direction are compared on the same axis of a normal direction with respect to the interface of the GaN crystal and the support substrate. Specifically, based on the interface, the Mn concentration at an arbitrary position that is away from the interface by more than 0 um but less than 2 um in the normal direction is compared with the Mn concentration at an arbitrary position that is away from the interface by 2 um or more.

It was discovered by the present inventors that, when the Mn concentration at a position less than 2 um away from an interface of the GaN crystal and the support substrate in the [0001] direction is 20 times or less of the Mn concentration at a position 2 um or more away from the interface in the [0001] direction, crack generation can be inhibited in a post-process such as polishing. In addition, it was confirmed that an increase in the density of threading dislocations introduced by crystal growth can be inhibited as well.

Usually, when an Mn-doped GaN crystal is grown from a support substrate, the interface thereof tends to have a high Mn concentration. This is believed to be because manganese vapor is introduced to the seed substrate. For example, when a target Mn concentration is 3.0 × 10¹⁷ atoms/cm³, it is necessary to raise the surrounding temperature of Mn metal to 800°C; however, it is believed that, in the process before the temperature reaches 800°C, manganese vapor is supplied onto the seed substrate prior to the start of the growth of the GaN crystal. It was found that, when Mn at the interface is concentrated in this manner, a problem of an increase in the threading dislocation density may occur; however, the present inventors discovered that this problem can be inhibited by satisfying the above-described standard.

The ratio of the Mn concentration at a position less than 2 um away from the interface in the [0001] direction with respect to the Mn concentration at a position 2 um or more away from the interface in the [0001] direction is preferably 20 times or less, more preferably 10 times or less, still more preferably 5 times or less, particularly preferably 2 times or less.

Further, when the thickness of the GaN substrate is 10.0 µm or more, as a modification example of the third embodiment, a condition "a ratio of the Mn concentration measured at a spot 1.0 um away from an interface of the GaN crystal and the support substrate in the [0001] direction with respect to an average value of the Mn concentration measured at 1.0-um intervals for a total of 9 spots that are positioned 2.0 um to 10.0 um away from the interface in the [0001] direction is 20 times or less" can be applied to the condition according to the third embodiment, which is "the Mn concentration at a position less than 2 um away from an interface of the GaN crystal and the support substrate in the [0001] direction is 20 times or less of the Mn concentration at a position 2 um or more away from the interface in the [0001] direction", and the above-described ratio is preferably 10 times or less, more preferably 5 times or less, still more preferably 2 times or less.

Moreover, as another modification example, a condition "a ratio of the Mn concentration measured at a spot 1.0 um away from an interface of the GaN crystal and the support substrate in the [0001] direction with respect to an average value of the Mn concentration measured at 10-pm intervals from a position 2.0 um away from the interface in the [0001] direction to the outermost surface is 20 times or less" can also be applied, and this ratio is preferably 10 times or less, more preferably 5 times or less, still more preferably 2 times or less.

A method of producing a GaN substrate having the above-described characteristic of Mn concentration is not limited. Specific examples thereof include, as described below, a method in which the growth of a GaN crystal is initiated in a temperature range where the supply amount of manganese vapor is small, and a method in which an Mn raw material and a Ga raw material are heated using separate heaters.

The third embodiment of the present invention is also a preferred mode of the above-described second embodiment, including modification examples. Further, all of the matters described above for the first and the second embodiments are also applicable as preferred modes of the third embodiment.

### 3. Method of Growing GaN Crystal

One example of a method of producing the GaN crystal according to the first embodiment will now be described.
The GaN crystal according to the first embodiment is usually grown by HVPE.

An HVPE apparatus suitable for growing the GaN crystal according to the first embodiment and conditions used for growing the GaN crystal according to the first embodiment using the apparatus are described below.

### 3.1. HVPE Apparatus

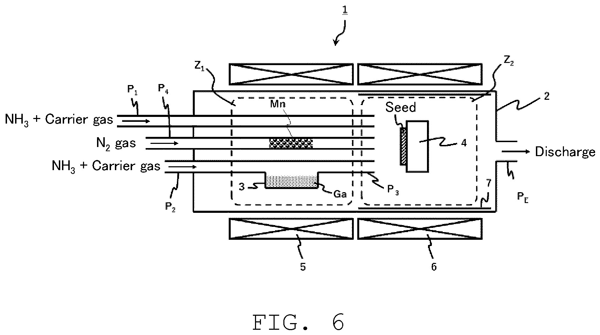

FIG. 6 schematically illustrates a basic configuration of an HVPE apparatus suitable for growing the GaN crystal according to the first embodiment.

Referring to FIG. 6, an HVPE apparatus 1 includes: a hot wall-type reactor 2; a gallium reservoir 3 and a susceptor 4, which are arranged inside the reactor; and a first heater 5 and a second heater 6, which are arranged on the outside of the reactor. The first heater 5 and the second heater 6 each circularly surround the reactor 2.

The reactor 2 is a quartz tube chamber. Inside the reactor 2, there are a first zone Z₁ mainly heated by the first heater 5, and a second zone Z₂ mainly heated by the second heater 6. An exhaust pipe P_{E} is connected to a reactor end on the side of the second zone Z₂.

The gallium reservoir 3 arranged in the first zone Z₁ is a container having a gas inlet and a gas outlet, and may be formed of carbon or quartz, or a combination of a carbon part and a quartz part.

The susceptor 4 arranged in the second zone Z₂ is formed of, for example, but not limited to graphite, and may be formed of a metal having excellent heat resistance and corrosion resistance such as W (tungsten) or Mo (molybdenum), or may be a heat-resistant ceramic such as SiC, whose surface is coated with pyrolytic graphite. A mechanism for rotating the susceptor 4 may be arranged as desired.

In the second zone Z₂, the inner wall of the reactor 2 and a gas flowing in the reactor 2 are prevented from coming into contact with each other by a sleeve 7 inserted into the reactor 2. The sleeve 7 is formed of a flexible graphite sheet or a pyrocarbon-coated cylindrical graphite, and has an outer diameter slightly smaller than the inner diameter of the reactor 2. The sleeve 7 may be in contact or tightly adhered with the reactor 2, or may have a small gap with the reactor 2. The present inventors believe that the installation of the sleeve 7 is effective for reducing the Si concentration in the GaN crystal to be grown. This is because the presence of the sleeve 7 inhibits the introduction of Si element, which originates from the reactor 2 formed of a quartz tube, into the GaN crystal.

In order to grow a GaN crystal using the HVPE apparatus 1, after putting metal gallium in the gallium reservoir 3 and placing a seed on the susceptor 4, the first zone Z₁ and the second zone Z₂ are heated by the first heater 5 and the second heater 6, respectively. At the same time, NH₃ (ammonia) diluted with a carrier gas is supplied to the second zone Z₂ through an ammonia introduction pipe P₁, and HCl (hydrogen chloride) diluted with a carrier gas is supplied to the gallium reservoir 3 through a hydrogen chloride introduction pipe P₂. This HCl reacts with the gallium metal contained in the gallium reservoir 3, and the resulting GaCl (gallium chloride) is transferred to the second zone Z₂ through a gallium chloride introduction pipe P₃. In the second zone Z₂, NH₃ and GaCl react with each other, and the resulting GaN is crystallized on the seed.

When doping the GaN crystal growing on the seed with Mn, N₂ or the like is introduced to the reactor 2 through a dopant introduction pipe P₄ in which metal Mn is arranged. Mn can also be doped by passing HCl or H₂ through the dopant introduction pipe P₄; however, particularly in order to reduce the concentration of Si which is a donor impurity, it is preferred to select N₂. It is believed that, when N₂ is selected as the carrier gas, the surface of Mn is converted to a nitride inside the dopant introduction pipe P₄, and this Mn in the form of a nitride is vaporized and thereby released into the second zone Z₂ as a dopant source.

The vapor pressure of manganese has a positive correlation with temperature; therefore, the Mn concentration in the GaN crystal can be adjusted by changing the temperature of the zone Z₁ in which Mn is arranged.

As for the ammonia introduction pipe P₁, the hydrogen chloride introduction pipe P₂, the gallium chloride introduction pipe P₃, and the dopant introduction pipe P₄, those parts exposed to a high temperature in the reactor can be formed of quartz.

Particularly, a nozzle of the gallium chloride introduction pipe P₃ is preferably formed of a carbon material such as pyrolytic graphite or W (tungsten), rather than quartz, since the nozzle is positioned inside the second zone Z₂ heated to a higher temperature than the first zone Z₁, and H₂ generated as a by-product of GaCl-forming reaction flows therethrough.

In experiments conducted by the present inventors using an HVPE apparatus having the same basic configuration as the HVPE apparatus 1, the Si concentration in a GaN crystal that was grown using only N₂ as the carrier gas without intentional doping was reduced by half when the nozzle of the gallium chloride introduction pipe was changed from a quartz tube to a pyrolytic graphite tube. It is noted here that the O concentration of this GaN crystal was not affected by the nozzle change.

In FIG. 6, the nozzle of the ammonia introduction pipe P₁ and the nozzle of the gallium chloride introduction pipe P₃ are independent from each other; however, in a preferred example, a double-pipe nozzle in which the former is an outer pipe and the latter is an inner pipe may be employed. In this case, the diameter of the outer pipe can be increased up to the inner diameter of the reactor.

In FIG. 6, the nozzle of the gallium chloride introduction pipe P₃ and the nozzle of the dopant introduction pipe P₄ are independent from each other; however, in a preferred example, it may be configured such that GaCl and a dopant source are mixed and then released into the second zone Z₂ through a common nozzle so that the growing GaN crystal is uniformly doped with Mn. For this purpose, for example, the nozzle of the dopant introduction pipe P₄ may be arranged inside the gallium chloride introduction pipe P₃.

In the HVPE apparatus 1 illustrated in FIG. 6, the reactor 2 may be changed from a horizontal type to a vertical type without modifying the basic configuration. The reactor changed to a vertical type may have either a configuration in which a raw material gas flows in the reactor in the top-to-bottom direction, or a configuration in which a raw material gas flows in the opposite direction.

3.2. Seed

When growing the GaN crystal according to the present embodiment, it is preferred to use a c-plane single-crystal GaN substrate as the seed. As the seed, it is also preferred to use a GaN substrate that is not intentionally doped.

A c-plane single-crystal GaN substrate, particularly a c-plane single-crystal GaN substrate that is not intentionally doped, usually has a dislocation density of less than 1 × 10⁷ cm⁻²; therefore, on the (0001) surface thereof, an Mn-doped GaN layer having a good surface flatness can be grown.

When a GaN/sapphire template is used as the seed, the growth surface morphology of the resulting Mn-doped GaN layer is deteriorated as compared to an undoped GaN layer grown on the same seed; however, an undoped GaN layer and a GaN layer having an Mn concentration of about 2 × 10¹⁷ cm⁻³ that were each grown on a c-plane single-crystal GaN substrate by the present inventors both had a flat surface, and a distinguishable morphology difference was not found between these GaN layers under a differential interference microscope. Accordingly, it was confirmed that the use of a c-plane single-crystal GaN substrate as the seed enables flat growth of an Mn-doped GaN crystal comparable to an undoped GaN crystal.

The present inventors believe that the growth surface morphology can affect the O (oxygen) concentration of the resulting GaN crystal. The concentration of O incorporated into a GaN layer growing in the [0001] direction can be different by 50 times or more between a flat growth surface and an irregular growth surface even under the same growth environment. The O concentration of the GaN layer is reduced when the growth surface is a flat surface parallel to the (0001) crystal plane.

As the seed, a GaN substrate obtained by a vapor-phase method such as HVPE or a GaN substrate obtained by a liquid-phase method such as an ammonothermal method may be used. The ammonothermal method may be either an acidic ammonothermal method or a basic ammonothermal method.

In a preferred example, a c-plane single-crystal GaN substrate, which is grown by an acidic ammonothermal method using NH₄F (or HF) and NH₄I (or HI) as mineralizers and has a

(0004) XRD rocking curve full width at half maximum of less than 20 arcsec, can be used as the seed. With regard to production procedure of such a c-plane single-crystal GaN substrate, reference can be made to WO2018/030311. In a case where a GaN substrate produced by a liquid-phase method such as an ammonothermal method is used as the seed, an Mn-doped GaN crystal having a further reduced threading dislocation density can be obtained as compared to a case where a GaN substrate produced by HVPE is used as the seed.

### 3.3. Carrier Gas

When growing the GaN crystal according to the present embodiment by HVPE, it is desired to minimize the use of H₂ (hydrogen gas) as the carrier gas as much as possible. Preferably, only an inert gas such as N₂ (nitrogen gas) or noble gas is used as the carrier gas. The inert gas is preferably N₂.

The reason why it is not preferred to use H₂ as the carrier gas is because H₂ contributes to decomposition of quartz used as a material of the reactor and pipes, and this is believed to be the main cause of the occurrence of unintended Si doping of the GaN crystal to be grown.

### 3.4. Temperature Condition

When the HVPE apparatus 1 illustrated in FIG. 6 is used, the temperature of the first zone Z₁ does not have a large effect on the impurity concentrations of the GaN crystal to be grown.

According to experiments in which an HVPE apparatus having the same basic configuration as the HVPE apparatus 1 was used (only N₂ was used as a carrier gas), when the temperature of the gallium reservoir was changed between 440°C and 840°C while the susceptor temperature was fixed at 1,030°C, a GaN crystal grown without intentional doping was not observed to have a substantial change in the Si concentration, the O concentration, the C concentration, and the H concentration. In addition, the growth rate of the GaN crystal was substantially constant.

However, when the temperature of the gallium reservoir was set at 900°C or higher, it was observed that the Si concentration and the C concentration tended to be increased in the grown GaN crystal.

On the other hand, the effect of the temperature T₂ of the second zone Z₂ on the impurity concentrations of the GaN crystal to be grown is not small.

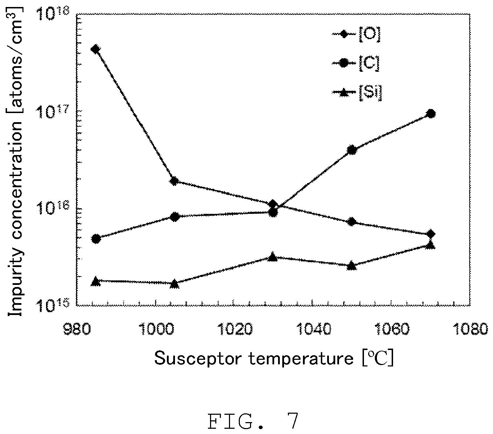

FIG. 7 shows the relationship between the susceptor temperature and the impurity concentrations of a grown GaN crystal, which was determined from experiments in which an HVPE apparatus having the same basic configuration as the HVPE apparatus 1 was used.

In these experiments, the temperature of the gallium reservoir was fixed at 840°C, and the susceptor temperature was changed between 985°C and 1,070°C. Only N₂ was used as a carrier gas, and GaCl and NH₃ were supplied to the reactor at a flow rate of 40 sccm and 500 sccm, respectively, to grow a GaN crystal on a single-crystal c-plane GaN substrate without intentional doping.

As shown in FIG. 7, by raising the susceptor temperature from 985°C to 1,005°C, the O concentration of the grown GaN crystal was reduced by one digit from the order of 10¹⁷ atoms/cm³ to the order of 10¹⁶ atoms/cm³, and the O concentration was further reduced to the order of 10¹⁵ atoms/cm³ by further raising the susceptor temperature. It is surmised that a higher temperature resulted in a further improvement in the surface flatness of the growing GaN layer, making O less likely to be incorporated therein.

On the other hand, the Si concentration of the grown GaN crystal did not exceed 5 × 10¹⁵ atoms/cm³, although it tended to increase with the susceptor temperature.

The C concentration of the grown GaN crystal also exhibited a tendency of increasing with the susceptor temperature.

### 3.5. Mn Doping

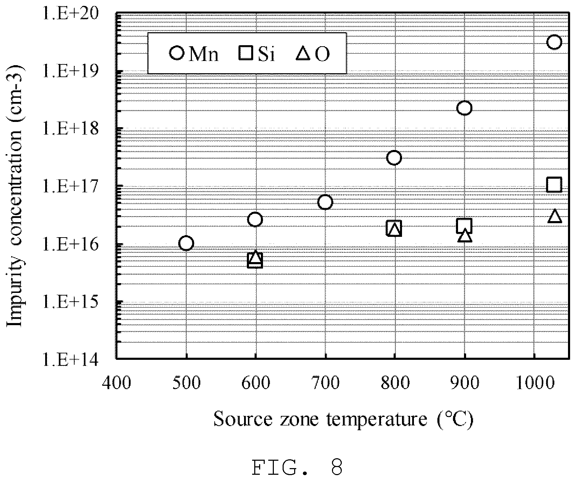

When the present inventors conducted experiments in which, using an HVPE apparatus having the same basic configuration as the HVPE apparatus 1, a N₂ carrier gas was supplied at rate of 50 sccm to the dopant introduction pipe in which metal Mn was arranged and the temperature T₁ of the first zone Z₁ was changed, the Mn concentration of a GaN crystal grown at 1,030°C on a single-crystal c-plane GaN substrate varied substantially in proportion to the temperature T₁ between 1 × 10¹⁶ atoms/cm³ and 3 × 10¹⁸ atoms/cm³ as shown in FIG. 8.

In these experiments, not only the carrier gas supplied to the dopant introduction pipe P₄, but also all of the carrier gases supplied to the reactor were N₂. Actually, the dopant introduction pipe P₄ and Ga reservoir 3 are positioned close to each other and thus heated by the same heater. Therefore, when the target Mn doping amount is 2.2 × 10¹⁸ atoms/cm³, the set temperature of the dopant introduction pipe is 900°C.

In this manner, when the temperature of the dopant introduction pipe is set at 900°C prior to the start of the growth of a GaN crystal, since an Mn precursor is transferred to the substrate surface, the Mn concentration in the initial stage of the crystal growth is increased. Meanwhile, it is known that the growth rate of a GaN crystal is not reduced even when the temperature T₁ is 500°C. Therefore, by maintaining the temperature T₁ at 500°C until the start of the growth and performing heating to a target set temperature such as 900°C after the start of the growth, the Mn concentration in the initial stage of the growth can be reduced. From this standpoint, the temperature T₁ prior to the start of the growth is preferably in a range of 400°C to 600°C, more preferably in a range of 450°C to 550°C. This method is one of effective means for achieving the third embodiment of the present invention.

As the conditions of a method of growing a GaN crystal, general conditions in HVPE can be applied, except for the above-described matters.

### 4. Use of Substrate

The GaN substrates (particularly, single-crystal GaN substrates) according to the second embodiment and the third embodiment (hereinafter, these embodiments are also collectively referred to as "second embodiment and the like") can each be preferably used for the production of a nitride semiconductor device, particularly a nitride semiconductor device having a horizontal device structure. Specifically, a nitride semiconductor device can be produced by a method that includes: the step of preparing the above-described GaN substrate; and the step of epitaxially growing at least one nitride semiconductor layer on the thus prepared substrate.

A nitride semiconductor is also called "nitride-based Group III-V compound semiconductor", "Group III nitride-based compound semiconductor", "GaN-based semiconductor" or the like, and contains GaN along with a compound obtained by partially or entirely substituting gallium of GaN with other Periodic Table Group 13 element (e.g., B, Al, or In).

A typical example of the nitride semiconductor device having a horizontal device structure is a GaN-HEMT (High Electron Mobility Transistor), and a horizontal device structure can be employed not only in electronic devices other than HEMTs such as bipolar transistors, but also in light-emitting devices such as light-emitting diodes (LEDs) and laser diodes (LDs).

Examples of a substrate formed of the GaN crystal according to the first embodiment include, in addition to the single-crystal GaN substrates according to the second embodiment and the like, those substrates obtained by laminating a GaN layer formed of the GaN crystal according to the first embodiment on a support substrate by means of a bonding technology. Such substrates can also be used for the same applications as the single-crystal GaN substrates according to the second embodiment and the like.

Further, the GaN crystal according to the first embodiment and the GaN substrates according to the second embodiment and the like can each be used as an epitaxial wafer by laminating thereon at least one epitaxially grown nitride semiconductor layer. A method of producing such an epitaxial wafer is not particularly limited and, for example, the epitaxial wafer can be produced by a method which includes: the step of preparing the above-described GaN substrate; and the step of epitaxially growing at least one nitride semiconductor layer on the thus prepared substrate.

### 5. Experimental Results

### 5.1. Experiment 1

### (1) Growth of Mn-doped GaN Crystal

As a seed, a c-plane single-crystal GaN substrate (20-mm square) grown by HVPE, which had a dislocation density of about 2 × 10⁶ to 4 × 10⁶ cm⁻², was prepared.

On the (0001) surface of this c-plane single-crystal GaN substrate, a GaN crystal layer was grown by the following procedure using an HVPE apparatus having the same basic configuration as the HVPE apparatus illustrated in FIG. 6.

First, the seed was set on the susceptor, and the reactor was subsequently heated while introducing thereto N₂ and NH₃ at a flow rate of 2,700 sccm and 500 sccm, respectively.

Then, once the temperature T₁ of the first zone Z₁ reached 500°C and the temperature T₂ of the second zone Z₂ reached 1,030°C, these temperatures were maintained constant, and GaCl and NH₃ were supplied at a flow rate of 40 sccm and 500 sccm, respectively, to initiate the growth of a GaN crystal. Using only N₂ as a carrier gas supplied during the growth, the N₂ carrier gas was supplied to the dopant introduction pipe at a flow rate of 50 sccm, and the growth was allowed to proceed until the thickness of the resulting GaN crystal layer reached 50 um, whereby an Mn-doped GaN single crystal having a (0001) surface was obtained. The crystal growth surface of this Mn-doped single crystal had an inclination of 0° from the (0001) crystal plane. The growth rate of the Mn-doped GaN crystal layer was 1.7 µm/min.

The following evaluations were performed using the thus obtained Mn-doped GaN single crystal grown on the seed substrate as is.

### (2) Impurity Concentration

As a result of measurement by SIMS, the Mn concentration of the Mn-doped GaN crystal layer was found to be 1.0 × 10¹⁶ atoms/cm³. Further, it is presumed that the total donor impurity concentration of Si and O was substantially equal to or lower than that in Experiment 2 where the temperature T₁ was higher than in Experiment 1.

### (3) Evaluation of Crystallinity

Dislocations, which are defects of a GaN crystal, are observed as dark spots by cathodoluminescence (CL) method. Therefore, the dark spot density of the Mn-doped GaN crystal layer was evaluated based on dark spots observed by CL method. In a field of view at a magnification of ×2,000, the dark spot density was 1.8 × 10⁶ cm⁻², and it was confirmed that, even when Mn was doped, an increase in the amount of dislocations was not observed as compared to the c-plane single-crystal GaN substrate prepared as the seed, and that an Mn-doped GaN crystal having a good quality was obtained.

### 5.2. Experiment 2

### (1) Growth of Mn-doped GaN Crystal

In contrast to Experiment 1 where the temperature T₁ of the first zone Z₁ was constant at 500°C, the T₁ was maintained at 500°C for 5 minutes and subsequently increased to 600°C over a period of 10 minutes, after which a GaN crystal layer was allowed to grow at a constant temperature of 600°C until the thickness reached 50 um. Other conditions were the same as in Experiment 1. The crystal growth surface of the thus obtained Mn-doped crystal had an inclination of 0° from the (0001) crystal plane.

### (2) Impurity Concentration

The impurity concentrations of an Mn-doped GaN crystal layer obtained by the same method as in Experiment 1 were as follows: Mn = 2.5 × 10¹⁶ atoms/cm³, Si = 5.0 × 10¹⁵ atoms/cm³, O = 6.0 × 10¹⁵ atoms/cm³, C = 2.0 × 10¹⁶ atoms/cm³, and H = 3.5 × 10¹⁶ atoms/cm³.

### (3) Evaluation of Crystallinity

The dark spot density of the Mn-doped GaN crystal layer, which was evaluated by the same method as in Experiment 1, was 2.3 × 10⁶ cm⁻², and it was confirmed that, even when Mn was doped, an increase in the amount of dislocations was not observed as compared to the c-plane single-crystal GaN substrate prepared as the seed, and that an Mn-doped GaN crystal having a good quality was obtained.

### 5.3. Experiment 3

### (1) Growth of Mn-doped GaN Crystal

In contrast to Experiment 1 where the temperature T₁ of the first zone Z₁ was constant at 500°C, the T₁ was maintained at 500°C for 5 minutes and subsequently increased to 700°C over a period of 10 minutes, after which a GaN crystal layer was allowed to grow at a constant temperature of 700°C until the thickness reached 50 um. Other conditions were the same as in Experiment 1. The crystal growth surface of the resulting Mn-doped crystal had an inclination of 0° from the (0001) crystal plane.

### (2) Impurity Concentration

The Mn concentration of an Mn-doped GaN crystal layer obtained by the same method as in Experiment 1 was 5.0 × 10¹⁶ atoms/cm³.

### (3) Evaluation of Crystallinity

The dark spot density of the Mn-doped GaN crystal layer, which was evaluated by the same method as in Experiment 1, was 1.8 × 10⁶ cm⁻², and it was confirmed that, even when Mn was doped, an increase in the amount of dislocations was not observed as compared to the c-plane single-crystal GaN substrate prepared as the seed, and that an Mn-doped GaN crystal having a good quality was obtained. Further, in this Experiment 3, the temperature T₁ was in the middle of that in Experiment 2 and that in Experiment 4; therefore, it is presumed that the total donor impurity concentration of Si and O was about 2 × 10¹⁶ atoms/cm³.

### 5.4. Experiment 4

### (1) Growth of Mn-doped GaN Crystal

In contrast to Experiment 1 where the temperature T₁ of the first zone Z₁ was constant at 500°C, the T₁ was maintained at 500°C for 5 minutes and subsequently increased to 800°C over a period of 10 minutes, after which a GaN crystal layer was allowed to grow at a constant temperature of 800°C until the thickness reached 50 um. Other conditions were the same as in Experiment 1. The crystal growth surface of the thus obtained Mn-doped crystal had an inclination of 0° from the (0001) crystal plane.

### (2) Impurity Concentration

The impurity concentrations of an Mn-doped GaN crystal layer obtained by the same method as in Experiment 1 were as follows: Mn = 3.0 × 10¹⁷ atoms/cm³, Si = 1.8 × 10¹⁶ atoms/cm³, O = 1.7 × 10¹⁶ atoms/cm³, C = 6.0 × 10¹⁵ atoms/cm³, and H = 2.4 × 10¹⁶ atoms/cm³.

### (3) Evaluation of Crystallinity

The dark spot density of the Mn-doped GaN crystal layer, which was evaluated by the same method as in Experiment 1, was 1.5 × 10⁶ cm⁻², and it was confirmed that, even when Mn was doped, an increase in the amount of dislocations was not observed as compared to the c-plane single-crystal GaN substrate prepared as the seed, and that an Mn-doped GaN crystal having a good quality was obtained.

### 5.5. Experiment 5

### (1) Growth of Mn-doped GaN Crystal

In contrast to Experiment 1 where the temperature T₁ of the first zone Z₁ was constant at 500°C, the T₁ was maintained at 500°C for 5 minutes and subsequently increased to 900°C over a period of 10 minutes, after which a GaN crystal layer was allowed to grow at a constant temperature of 900°C until the thickness reached 50 um. Other conditions were the same as in Experiment 1. The crystal growth surface of the thus obtained Mn-doped crystal had an inclination of 0° from the (0001) crystal plane.

### (2) Impurity Concentration

When a cross-section of the thus obtained Mn-doped GaN crystal was observed under a fluorescence microscope, the growth layer was composed of two layers. Defining the two layers as a first layer and a second layer sequentially from the seed side, these layers had a thickness of 8.5 um and 41.5 um, respectively. The impurity concentrations of the first layer were as follows: Mn = 1.0 × 10¹⁶ atoms/cm³, Si = 5.0 × 10¹⁵ atoms/cm³, O = 6.0 × 10¹⁵ atoms/cm³, C = 2.0 × 10¹⁶ atoms/cm³, and H = 3.5 × 10¹⁶ atoms/cm³. Further, the impurity concentrations of the second layer were as follows: Mn = 2.2 × 10¹⁸ atoms/cm³, Si = 2.0 × 10¹⁶ atoms/cm³, O = 1.4 × 10¹⁶ atoms/cm³, C = 1.8 × 10¹⁶ atoms/cm³, and H = 2.7 × 10¹⁶ atoms/cm³. That is, the Mn concentration of the first layer was 0.0045 times of the Mn concentration of the second layer.

Regarding the Mn concentration, when a condition "a ratio of the Mn concentration measured at a spot 1.0 um away from an interface of the GaN crystal and the support substrate in the [0001] direction with respect to an average value of the Mn concentration measured at 1.0-pm intervals for a total of 9 spots that are positioned 2.0 um to 10.0 um away from the interface in the [0001] direction" is applied, this concentration ratio is 0.75 times.

Further, when a condition "a ratio of the Mn concentration measured at a spot 1.0 um away from an interface of the GaN crystal and the support substrate in the [0001] direction with respect to an average value of the Mn concentration measured at 10-pm intervals from a position 2.0 um away from the interface in the [0001] direction to the outermost surface" is applied, this concentration ratio is 0.0075 times.

The dark spot density of the Mn-doped GaN crystal layer, which was evaluated by the same method as in Experiment 1, was 2.3 × 10⁶ cm⁻², and it was confirmed that, even when Mn was doped, an increase in the amount of dislocations was not observed as compared to the c-plane single-crystal GaN substrate prepared as the seed, and that an Mn-doped GaN crystal having a good quality was obtained.

### 5.6. Experiment 6

### (1) Preparation of GaN Substrate

An Mn-doped c-plane single-crystal GaN substrate was prepared by the substantially the same procedure as in Experiment 4, except that a c-plane single-crystal GaN substrate, which was grown by an acid ammonothermal method using NH₄F and NH₄I as mineralizers, was used as the seed. The c-plane single-crystal GaN substrate grown by the ammonothermal method had a (0004) XRD rocking curve full width at half maximum of about 10 arcsec. The crystal growth surface of the thus obtained Mn-doped crystal had an inclination of 0° from the (0001) crystal plane.

### (2) (0004) XRD Rocking Curve Full Width at Half Maximum

The (0004) XRD rocking curve full width at half maximum of the Mn-doped GaN substrate prepared in the above (1) was measured using an X-ray diffractometer [PANALYTICAL X'Pert Pro MRD, manufactured by Spectris Co., Ltd.].

In this measurement, a line-focus CuKα radiation source was operated at 45 kV and 40 mA, and CuKα₁ radiation was obtained using a Ge (440) 4-crystal symmetrical monochromator. A parallel optical system was used, and a 1/2 slit, an X-ray mirror, and a 1 mm (width) × 1 mm (height) cross-slit were used on the incident side. As a detector, a semiconductor pixel detector PIXcel^{3D} (registered trademark) was used in the 0D mode. The angle resolution was 5 to 6 arcsec.

An X-ray was irradiated to the (0001) surface of a sample such that the plane of incidence was perpendicular to at least one m-axis. The beam size was set such that, when the angle of incidence was 90°, i.e. when the X-ray was irradiated perpendicular to the Ga-polar surface, an irradiated area had a size of 1 × 5 mm².

The value measured at one spot on the sample surface was 8.6 arcsec. From this value of the (0004) XRD rocking curve full width at half maximum, it was estimated that the dislocation density of the above-prepared Mn-doped GaN substrate did not exceed the order of 10⁵ cm⁻² at most, and an extremely high-quality crystal was obtained. It is noted here that, since the GaN crystal was grown under the same conditions as in Experiment 4 except that the GaN substrate used as the seed was different, it is believed that the impurity concentrations were substantially the same as in Experiment 4.

The results of the above-described experiments are shown in Table 1. In Table 1, "-" indicates that the measurement was not performed.

**[Table 1]**

| | Seed substrate | First zone temperature (°C) | Impurity concentration (atoms/cm³) | | | | | | Dark spot density (cm⁻²) | XRD rocking curve full width at half maximum (arcsec) |
|---|---|---|---|---|---|---|---|---|---|---|
| | | | Mn | C | H | Si | O | Total donoor amount | | |
| Experiment 1 | HVPE | 500 | 1.0 × 10¹⁶ | - | - | - | - | - | 1.8 × 10⁶ | - |
| Experiment 2 | HVPE | 500 → 600 | 2.5 × 10¹⁶ | 2.0 × 10¹⁶ | 3.5 × 10¹⁶ | 5.0 × 10¹⁵ | 6.0 × 10¹⁵ | 1.1 × 10¹⁶ | 2.3 × 10⁶ | - |
| Experiment 3 | HVPE | 500 → 700 | 5.0 × 10¹⁶ | - | - | - | - | - | 1.8 × 10⁶ | - |
| Experiment 4 | HVPE | 500 → 800 | 30 × 10¹⁷ | 6.0 × 10¹⁵ | 2.4 × 10¹⁶ | 1.8 × 10¹⁶ | 1.7 × 10¹⁶ | 3.5 × 10¹⁶ | 1.5 × 10⁶ | - |
| Experiment 5 | HVPE | 500 → 900 | 2.2 × 10¹⁸ | 1.8 × 10¹⁶ | 2.7 × 10¹⁶ | 2.0 × 10¹⁶ | 1.4 × 10¹⁶ | 3.4 × 10¹⁶ | 2.3 × 10⁶ | - |
| Experiment 6 | Ammonothermal | 500 → 800 | - | - | - | - | - | - | <1 × 10⁵ | 10 |

The present invention has been described based on concrete embodiments; however, these embodiments were presented as examples and should not limit the scope of the present invention. The embodiments described herein can each be variously modified without departing from the spirit of the present invention and, where feasible, may be combined with any feature described by another embodiment.

### DESCRIPTION OF SYMBOLS

- 1:: HVPE apparatus
- 2:: reactor
- 3:: gallium reservoir
- 4:: susceptor
- 5:: first heater
- 6:: second heater
- 7:: sleeve
- 10:: crystal
- 11:: (0001) surface
- 12:: (000-1) surface
- 100:: substrate
- 101:: (0001) surface
- 102:: (000-1) surface
- 110:: first region
- 120:: second region

## Claims

1. A GaN crystal, **characterized by** comprising a surface which has an inclination of 10° or less from a (0001) crystal plane and an area of 5 cm² or more, and having an Mn concentration of 1.0 × 10¹⁶ atoms/cm³ or higher but lower than 1.0 × 10¹⁹ atoms/cm³ and a total donor impurity concentration of lower than 5.0 × 10¹⁶ atoms/cm³.

2. The GaN crystal according to claim 1, wherein the Mn concentration is 6.0 × 10¹⁸ atoms/cm³ or lower.

3. The GaN crystal according to claim 1 or 2, wherein the Mn concentration is 1.0 × 10¹⁷ atoms/cm³ or higher.

4. The GaN crystal according to any one of claims 1 to 3, having a (004) XRD rocking curve full width at half maximum, which is measured on the side of the (0001) surface, of 40 arcsec or less.

5. The GaN crystal according to any one of claims 1 to 4, having a threading dislocation density of less than 1.0 × 10⁷ cm⁻² on the (0001) surface.

6. A GaN crystal, **characterized by** comprising a surface which has an inclination of 10° or less from a (0001) crystal plane and an area of 5 cm² or more, being semiinsulating, and satisfying at least one selected from the following (A) and (B):
(A) having a (0004) XRD rocking curve full width at half maximum, which is measured on the side of the (0001) surface, of 40 arcsec or less; and
(B) having a threading dislocation density of less than 1 × 10⁷ cm⁻² on the (0001) surface.

7. The GaN crystal according to claim 6, which is doped with Mn.

8. The GaN crystal according to claim 6 or 7, having a total donor impurity concentration of lower than 5.0 × 10¹⁶ atoms/cm³.

9. A GaN substrate, comprising the GaN crystal according to any one of claims 1 to 8.

10. A GaN substrate, **characterized by** comprising, as a main surface, a surface which has an inclination of 10° or less from a (0001) crystal plane, and having an Mn concentration of 1.0 × 10¹⁶ atoms/cm³ or higher but lower than 1.0 × 10¹⁹ atoms/cm³ and a total donor impurity concentration of lower than 5.0 × 10¹⁶ atoms/cm³.

11. The GaN substrate according to claim 9 or 10, which is a single-crystal GaN substrate.

12. The GaN substrate according to claim 10 or 11, which is laminated on a support substrate.

13. A method of producing an epitaxial wafer, the method comprising:
the step of preparing the GaN substrate according to any one of claims 10 to 12; and
the step of epitaxially growing at least one nitride semiconductor layer on the thus prepared substrate.

14. An epitaxial wafer, comprising:
the GaN substrate according to any one of claims 10 to 12; and
at least one nitride semiconductor layer epitaxially grown on the substrate.

15. A method of producing a nitride semiconductor device, the method comprising:
the step of preparing the GaN substrate according to any one of claims 10 to 12; and
the step of epitaxially growing at least one nitride semiconductor layer on the thus prepared substrate.

16. A method of producing a GaN-HEMT, the method comprising:
the step of preparing the GaN substrate according to any one of claims 10 to 12; and
the step of epitaxially growing at least one nitride semiconductor layer on the thus prepared substrate.

17. A GaN substrate, comprising a GaN crystal laminated on a support substrate,
wherein
the GaN crystal comprises a surface which has an inclination of 10° or less from a (0001) crystal plane and an area of 5 cm² or more, and
the Mn concentration at a position less than 2 um away from an interface of the GaN crystal and the support substrate in the [0001] direction is 20 times or less of the Mn concentration at a position 2 um or more away from the interface in the [0001] direction.
